# EUROPEAN PATENT SPECIFICATION

(11) **EP 3 554 208 B1**
(45) Date of publication and mention of the grant of the patent: **26.05.2021**
(21) Application number: 18166862.5
(22) Date of filing: 11.04.2018
(51) Int. Cl.: H05K 13/04, H05K 13/08

(54) **ELECTRONIC COMPONENT MOUNTING DEVICE AND METHOD FOR SETTING UP ELECTRONIC COMPONENT MOUNTING DEVICE**
VORRICHTUNG ZUR MONTAGE EINER ELEKTRONISCHEN KOMPONENTE UND VERFAHREN ZUR EINRICHTUNG EINER VORRICHTUNG ZUR MONTAGE EINER ELEKTRONISCHEN KOMPONENTE
DISPOSITIF DE MONTAGE DE COMPOSANT ÉLECTRONIQUE ET PROCÉDÉ D'ÉTABLISSEMENT DE DISPOSITIF DE MONTAGE DE COMPOSANT ÉLECTRONIQUE

(43) Date of publication of application: 16.10.2019
(73) Proprietor: Salcomp Oyj, 24101 Salo (FI)
(72) Inventor: VALJUS, Simo, 08200 Lohja (FI); SAVOLAINEN, Kari, 03220 Tervalampi (FI); KUOSMANEN, Pertti, 08350 Lohja (FI); HÄRKÄLÄ, Pekka, 08350 Lohja (FI); KANTOLA, Juha, 08700 Lohja (FI); MÄKELÄ, Vesa, 08200 Lohja (FI); NUMMENPÄÄ, Pekka, 24260 Salo (FI)
(74) Representative: Berggren Oy

(56) References cited:
- WO-A1-2014/049684
- US-A- 5 193 268
- US-A1- 2002 124 397

## Description

### TECHNICAL FIELD OF THE INVENTION

The present invention relates to an electronic component mounting device and a method for setting up an electronic component mounting device according to the preambles of the appended independent claims.

### BACKGROUND OF THE INVENTION

Various devices for mounting electronic components on a circuit board are known in the prior art. These devices are called electronic component mounting devices and they typically comprise a plurality of functional units, which each have a specific purpose in the component mounting process. A conveyor is used for conveying a circuit board to and from a component mounting position at which position the electronic components are to be mounted on the circuit board. The electronic components are mounted on the circuit board with a pick-up device that picks up electronic components one at a time from a suitable feeder and then places the electronic components on the circuit board. The electronic component mounting device typically comprises a plurality of feeders so that different kinds of electronic components can be mounted on the circuit board. The feeders are typically detachable, allowing them to be changed when needed. Examples of electronic component mounting devices are described in US 2002/0124397 A1, US 5193268 A and WO 2014/049684 A1.

A problem associated with the known electronic component mounting devices is that the feeders are not at an optimal position with respect to the pick-up device and the conveyor, because of which the mounting speed of electronic components on a circuit board can be slow. Another problem associated with the known electronic component mounting devices is that the feeders are difficult to attach to and detach from the device, and thus the changing of the feeders is time-consuming. Yet another problem associated with the known electronic component mounting devices is that malfunctions, such as feeding errors of the feeders are difficult to rectify. Yet another problem associated with the known electronic component mounting devices is that setting of pick-up positions for the pick-up devices is difficult.

### OBJECTIVES OF THE INVENTION

It is the main objective of the present invention to reduce or even eliminate the prior art problems presented above.

It is an objective of the present invention to provide an electronic component mounting device and a method for setting up an electronic component mounting device, which enable to increase the mounting speed of electronic components on a circuit board. It is a further objective of the present invention to provide an electronic component mounting device and a method for setting up an electronic component mounting device, which enable to easily and quickly change electronic component feeders of the device. It is also an objective of the present invention to provide an electronic component mounting device and a method for setting up an electronic component mounting device, which enable to easily rectify possible malfunctions, such as feeding errors of the electronic component feeders. It is also an objective of the present invention to provide an electronic component mounting device and a method for setting up an electronic component mounting device, which enable to easily and accurately set pick-up positions for the pick-up device.

In order to realise the above-mentioned objectives, the device and the method according to the invention are characterised by what is presented in the characterising parts of the appended independent claims. Advantageous embodiments of the invention are described in the dependent claims.

### DESCRIPTION OF THE INVENTION

An electronic component mounting device according to the invention comprises a conveyor for conveying a circuit board, feeders for feeding electronic components, and a pick-up device for picking up electronic components from the feeders and mounting the electronic components to the circuit board. The electronic component mounting device according to the invention further comprises a movable frame to which the feeders are detachably attached, said movable frame being movable between a first position at which the pick-up device is intended to pick up electronic components from the feeders and a second position at which the feeders are intended to be attached to and detached from the movable frame.

The electronic component mounting device according to the invention can be used for mounting leaded and/or surface mounted electronic components on a circuit board. The conveyor conveys the circuit board to and from a component mounting position at which position the electronic components can be mounted on the circuit board. When the circuit board is at the component mounting position and the movable frame is at the first position, the pick-up device can pick up electronic components one at a time from a suitable feeder and mount the electronic components on the circuit board. The pick-up device has a certain pick-up position for each feeder, at which position the pick-up device must be to be able to pick up electronic components from the feeder. The pick-up device can preferably be moved in two directions perpendicular to one another and to the pick-up direction of the pick-up device. Preferably, each of the feeders is arranged to feed electronic components of a certain type to the pick-up device.

The feeders may be arranged to feed axial and/or radial electronic components, such as resistors, capacitors and inductors, that are arranged successively on component tapes. The axial electronic components are attached between two component tapes, whereas the radial electronic components are attached to only one component tape. The electronic components are attached to the component tape(s) at their leads. The component pitch and the lead spacing on the component tape can vary depending on the electronic components used. In the feeder, the electronic components are typically detached from the component tape(s) one component at a time. This is done by cutting the leads of the electronic component using a cutting device.

The feeders are detachably attached to the movable frame that can be moved between the first position and the second position. The movement of the movable frame between the first position and the second position is preferably essentially rectilinear. Preferably, the direction of movement of the movable frame is essentially perpendicular to the direction of movement of the conveyor. Preferably, the pick-up device can be moved in the same direction as the movable frame. The movable frame may be arranged to be movable, for example, along rails. The movable frame can be moved manually or with a suitable actuator, such as a servo motor. The feeders may be fastened to the movable frame with quick-release fasteners.

When electronic components are mounted on the circuit board, the movable frame is kept at the first position so that the pick-up device can pick up electronic components from the feeders and then place them on the circuit board. The first position of the movable frame is chosen in such a manner that the feeders are at an optimal position with respect to the pick-up device and the conveyor, whereby the mounting speed of electronic components can be maximised. When a feeder needs to be changed or a possible malfunction of a feeder needs to be rectified, the movable frame is moved to the second position. The second position of the movable frame is chosen in such a manner that the feeders are within reach of a user so that the feeders can be easily attached to and detached from the movable frame.

An advantage of the electronic component mounting device according to the invention is that the feeders can be easily and quickly changed, and the feeders can be placed at an optimal position with respect to the pick-up device and the conveyor so that the mounting speed of electronic components on the circuit board is high. Another advantage of the electronic component mounting device according to the invention is that possible malfunctions, such as feeding errors of the feeders can be easily rectified. Yet another advantage of the electronic component mounting device according to the invention is that the pick-up positions of the pick-up device can be set easily and accurately.

According to an embodiment of the invention the first position of the movable frame is adjustable. This allows to choose the first position of the movable frame on a case by case basis. The first position of the movable frame can be chosen, for example, based on the position of the pick-up device and/or the conveyor. The first position of the movable frame may need to be changed, for example, in cases where one or more of the feeders or the pick-up device is changed. The first position of the movable frame may also need to be changed when the width of the conveyor is changed because of a different type circuit board.

According to an embodiment of the invention the electronic component mounting device comprises locking means for locking the movable frame at the first position and/or the second position. The locking means may comprise, for example, a cylinder that can press against one of the rails and thus prevent the movable frame from moving.

According to an embodiment of the invention the electronic component mounting device comprises moving means for moving the pick-up device. The moving means are preferably configured to move the pick-up device in two directions perpendicular to one another and to the pick-up direction of the pick-up device. Preferably, the moving means are configured to move the pick-up device in the same direction as the movable frame. The moving means may comprise suitable actuators for moving the pick-up device.

According to the invention the electronic component mounting device comprises a camera for capturing one or more images of the movable frame at the first position and the second position, and analysing means for analysing the one or more images using pattern recognition techniques to determine the coordinates of the first position and the second position. The camera is preferably located above the movable frame and arranged movable in the same direction as the movable frame. The camera is preferably arranged next to the pick-up device and moved with the same moving means that is used for moving the pick-up device. The analysing means comprise a memory and a processor, which are configured to determine the coordinates of the first position and the second position based on the images.

The coordinates of the first position and the second position are used in determining the coordinates of pick-up positions of the pick-up device. This is achieved by first calculating an offset between the first position and the second position based on the coordinates of the first and second positions, and then determining the coordinates of a pick-up position of the pick-up device for each feeder by moving the movable frame to the second position, moving the pick-up device to a third position at which the pick-up device can pick-up an electronic component from a feeder, determining the coordinates of the third position, and calculating the coordinates of the pick-up position of the pick-up device for the feeder by adding the offset to the coordinates of the third position. The offset between the first position and

the second position is calculated with the analysing means. The coordinates of the third position are determined by capturing with the camera one or more images of the pick-up device at the third position, and by analysing with the analysing means the one or more images using pattern recognition techniques.

According to the invention the camera is configured to capture one or more images of the pick-up device at a third position, at which position the pick-up device can pick up an electronic component from a feeder when the movable frame is at the second position, and the analysing means is configured to analyse the one or more images using pattern recognition techniques to determine the coordinates of the third position.

According to an embodiment of the invention the camera is configured to capture one or more images of the circuit board, and the analysing means is configured to analyse the one or more images using pattern recognition techniques to determine the positions of calibration and electronic component mounting holes in the circuit board. The image(s) is(are) captured when the circuit board is at the component mounting position. The camera is preferably located above the circuit board. The position information of the calibration and electronic component mounting holes is needed so that the pick-up device can place the electronic components in correct places on the circuit board.

The present invention also relates to a method for setting up an electronic component mounting device that comprises a movable frame to which feeders are detachably attached and a pick-up device for picking up electronic components from the feeders and mounting the electronic components to a circuit board that is conveyed with a conveyor. The method according to the invention comprises moving the movable frame to a first position at which the pick-up device is intended to pick up electronic components from the feeders, determining the coordinates of the first position, moving the movable frame to a second position at which the feeders are intended to be attached to and detached from the movable frame, determining the coordinates of the second position, calculating an offset between the first position and the second position based on the coordinates of the first and second positions, and determining the coordinates of a pick-up position of the pick-up device for each feeder by moving the movable frame to the second position, moving the pick-up device to a third position at which the pick-up device can pick up an electronic component from a feeder, determining the coordinates of the third position, and calculating the coordinates of the pick-up position of the pick-up device for the feeder by adding the offset to the coordinates of the third position.

The method according to the invention provides an easy and accurate way to teach pick-up positions for a pick-up device of an electronic component mounting device. In the method according to the invention the idea is to teach the picking up of electronic components from the feeders when the movable frame is at the second position, i.e. at a position where the pick-up device is not intended to pick up electronic components and then mount them on a circuit board. When the movable frame is at the second position, the feeders and the pick-up device that is taught to pick-up electronic components can be easily observed and are within reach of a user. The position at which the pick-up device can pick up an electronic component from the feeder when the movable frame is at the second position, i.e. the third position can be converted to the pick-up position of the pick-up device with the use of the offset. By a pick-up position of a pick-up device is meant a position at which the pick-up device can pick up an electronic component from a feeder when the movable frame is at the first position.

In the method according to the invention the pick-up position of the pick-up device for a feeder is determined by first determining the coordinates of the third position at which position the pick-up device can pick up an electronic component from the feeder when the movable frame is at the second position and then calculating the coordinates of the pick-up position by adding the offset to the coordinates of the third position. The coordinates of the positions are defined in a three-dimensional space wherein, for example, the second position of the movable frame can be chosen as an origin. By the offset between the first position and the second position of the movable frame is meant a vector from the second position to the first position. Thus, the coordinates of the pick-up position are obtained from the coordinates of the third position by transferring them to a point defined by the vector.

An advantage of the method according to the invention is that it enables to easily and accurately teach pick-up positions of a pick-up device for feeders of an electronic component mounting device. Another advantage of the method according to the invention is that the feeders can be placed at an optimal position with respect to the pick-up device and the conveyor so that the mounting speed of electronic components on the circuit board is high. Yet another advantage of the method according to the invention is that the feeders can be easily and quickly changed. Still another advantage of the method according to the invention is that possible malfunctions, such as feeding errors of the feeders can be easily rectified.

According to an embodiment of the invention the method comprises changing the first position of the movable frame by moving the movable frame to a new first position and determining its coordinates, and repeating the steps of calculating an offset between the first position and the second position based on the coordinates of the first and second positions, and determining the coordinates of a pick-up position of the pick-up device for each feeder. The change of the first position of the movable frame can be based, for example, on the position of the pick-up device and/or the conveyor. The first position of the movable frame may need to be changed, for example, in cases where a feeder or the pick-up device is changed. The first position of the movable frame may also need to be changed when the width of the conveyor is changed because of a different type circuit board.

According to an embodiment of the invention the step of determining the coordinates of the first position and the step of determining the coordinates of the second position comprise using a camera to capture one or more images of the movable frame, and analysing the one or more images using pattern recognition techniques. The camera is arranged to capture images of the movable frame both at the first position and at the second position. The camera is preferably located above the movable frame and arranged movable in the same direction as the movable frame. The camera is preferably arranged next to the pick-up device and moved with the same moving means that is used for moving the pick-up device. The images are analysed with analysing means that comprise a memory and a processor, which are configured to determine the coordinates of the first position and the second position based on the images.

According to an embodiment of the invention the step of determining the coordinates of the third position comprises using a camera to capture one or more images of the pick-up device, and analysing the one or more images using pattern recognition techniques. The image(s) is(are) captured when the pick-up device is at the third position. The camera is preferably located above the pick-up device and arranged movable in the same direction as the movable frame. The camera is preferably arranged next to the pick-up device and moved with the same moving means that is used for moving the pick-up device. The image(s) is(are) analysed with analysing means that comprise a memory and a processor, which are configured to determine, based on the image(s), the coordinates of the third position.

According to an embodiment of the invention the method comprises determining the positions of calibration and electronic component mounting holes in the circuit board. The position information of the calibration and electronic component mounting holes is needed so that the pick-up device can place the electronic components in correct places on the circuit board.

According to an embodiment of the invention the step of determining the positions of calibration and electronic component mounting holes in the circuit board comprises using a camera to capture one or more images of the circuit board, and analysing the one or more images using pattern recognition techniques. The image(s) is(are) captured when the circuit board is at the component mounting position. The camera is preferably located above the circuit board. The camera is preferably arranged next to the pick-up device and moved with the same moving means that is used for moving the pick-up device. The image(s) is(are) analysed with analysing means that comprise a memory and a processor, which are configured to determine, based on the image(s), the positions of the calibration and electronic component mounting holes.

The exemplary embodiments of the invention presented in this text are not interpreted to pose limitations to the applicability of the appended claims. The verb "to comprise" is used in this text as an open limitation that does not exclude the existence of also unrecited features. The features recited in the dependent claims are mutually freely combinable unless otherwise explicitly stated.

The exemplary embodiments presented in this text and their advantages relate by applicable parts to the device as well as the method according to the invention, even though this is not always separately mentioned.

### BRIEF DESCRIPTION OF THE DRAWINGS

- Fig. 1: illustrates an electronic component mounting device according to an embodiment of the invention in a component mounting state,
- fig. 2: illustrates a partial view of fig. 1,
- fig. 3: illustrates the electronic component mounting device of fig. 1 in a feeder changing state, and
- fig. 4: illustrates the electronic component mounting device of fig. 1 in a pick-up position teaching state.

### DETAILED DESCRIPTION OF THE DRAWINGS

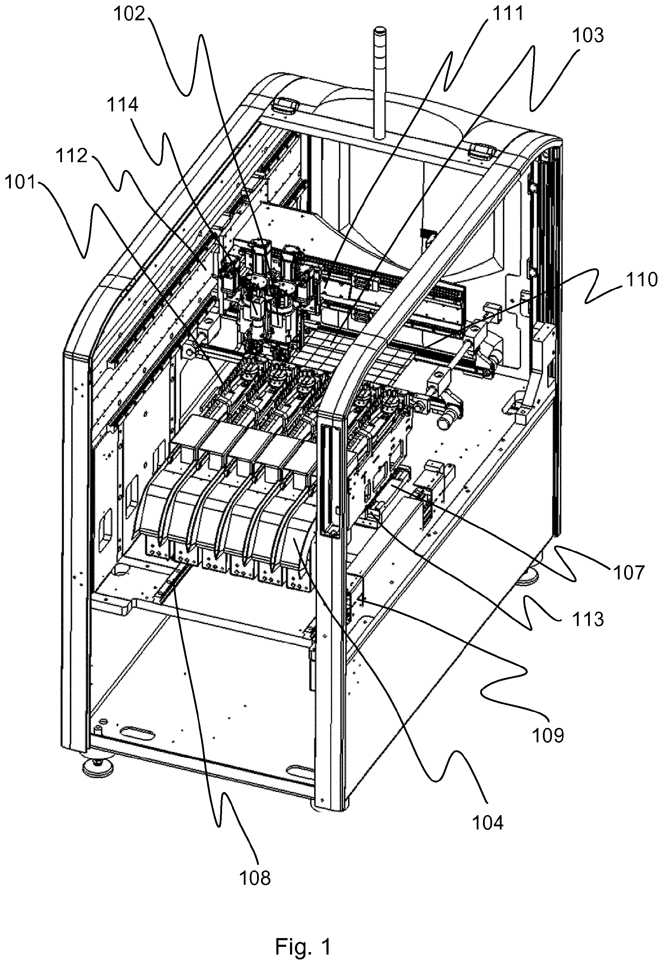

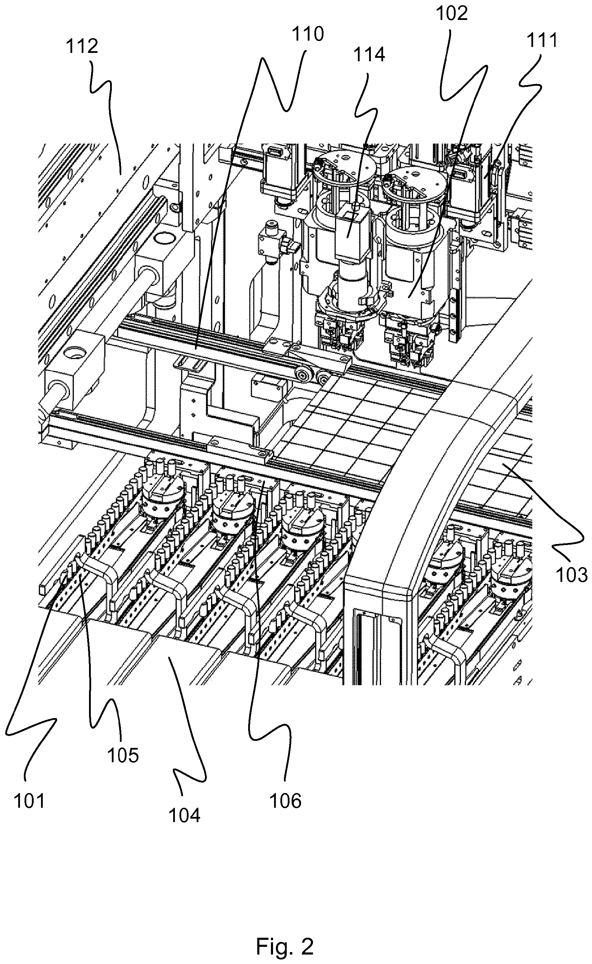

Fig. 1 illustrates an electronic component mounting device according to an embodiment of the invention in a component mounting state, i.e. in a state where electronic components 101 can be mounted with a pick-up device 102 on a circuit board 103. Fig. 2 illustrates a partial view of fig. 1.

The electronic component mounting device comprises a plurality of feeders 104 for feeding electronic components 101 to the pick-up device 102. In this illustrated embodiment, the electronic components 101 are radial electronic components that are arranged successively at their leads to a component tape 105. In the feeders 104, the electronic components 101 are detached from the component tape 105 one component at a time. This is done by cutting the leads of the electronic components 101 using a cutting device 106.

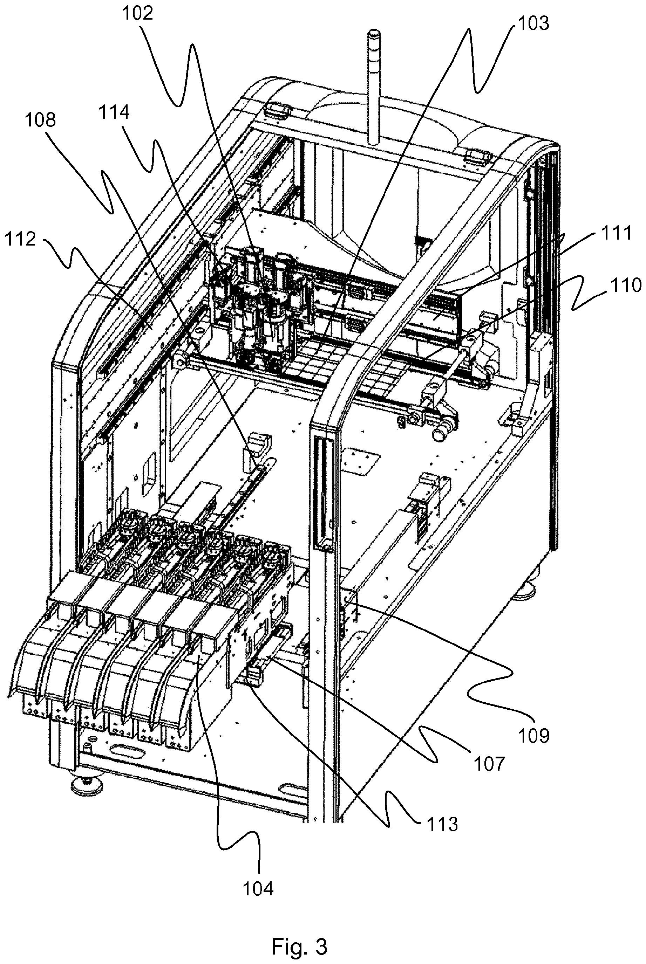

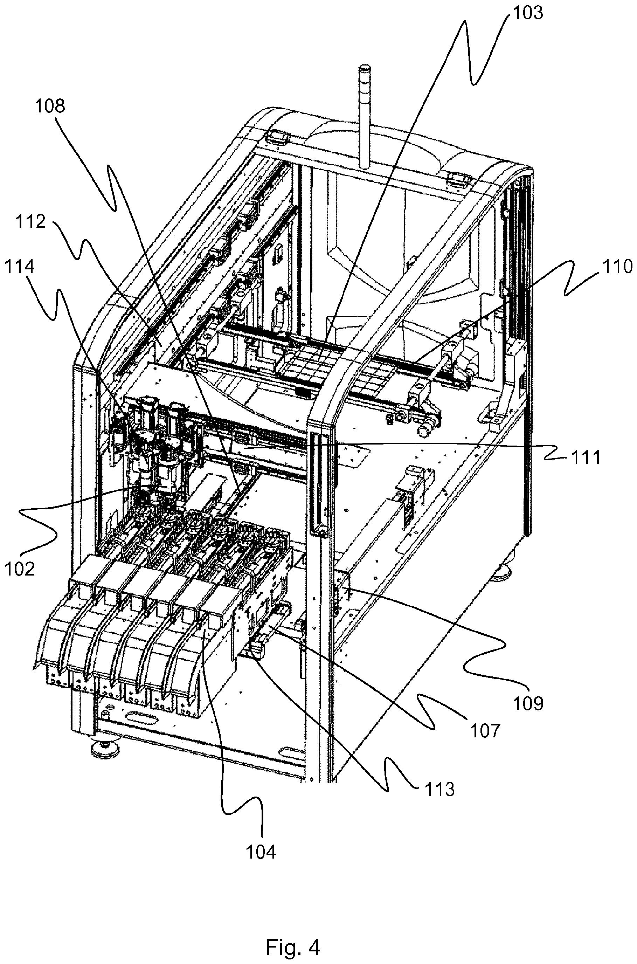

The feeders 104 are detachably attached to a movable frame 107 that can be moved between a first position (shown in fig. 1) and a second position (shown in figs. 3 and 4). The movable frame 107 is mounted on rails 108 along which it can be moved manually between the first and second positions. The movable frame 107 can be locked at the first position and the second position with a cylinder 109 that is arranged to press against one of the rails 108 and thus it can prevent the movable frame 107 from moving.

The electronic component mounting device comprises a conveyor 110 for conveying the circuit board 103. The conveyor 110 conveys the circuit board 103 to and from a component mounting position at which position the electronic components 101 can be mounted with the pick-up device 102 on the circuit board 103. In fig. 1, the circuit board 103 is shown located at the component mounting position.

When the movable frame 107 is at the first position as shown in fig. 1, the pick-up device 102 can pick up electronic components 101 from the feeders 104 and then mount the electronic components 101 on the circuit board 103. The pick-up device 102 has a certain pick-up position for each feeder 104. This means that the pick-up device 102 must be located at a certain position so that it can pick up electronic components 101 from a certain feeder 104 when the movable frame 107 is at the first position. The pick-up device 102 can be moved in two directions perpendicular to one another and to the pick-up direction of the pick-up device by using two actuators 111 and 112. The first actuator 111, to which the pick-up device 102 is attached, can move the pick-up device 102 in a direction that corresponds to the direction of movement of the conveyor 110. The first actuator 111 is attached to the second actuator 111, which can move the pick-up device 102 in a direction that corresponds to the direction of movement of the movable frame 107.

When the movable frame 107 is at the second position as shown in fig. 3, the feeders 104 can be attached to and detached from the movable frame 107. The feeders 104 are fastened to the movable frame with quick-release fasteners 113 allowing the feeders 104 to be easily and quickly changed.

The electronic component mounting device comprises a camera 114 for capturing images. The camera 114 is arranged next to the pick-up device 102 and attached to the first actuator 111 so that it can be moved with the actuators 111 and 112 in two directions perpendicular to one another. The camera 114 is configured to capture images of the movable frame 107 at the first position and the second position so that the coordinates of the first position and the second position of the movable frame 107 can be determined. The coordinates of the first position and the second position are used in determining the coordinates of pick-up positions of the pick-up device 102. This is achieved by first calculating an offset between the first position and the second position based on the coordinates of the first and second positions, and then teaching the pick-up positions of the pick-up device 102 for the feeders 104. The pick-up position teaching state is shown in fig. 4. In this state, the movable frame 107 is at the second position and the pick-up device 102 is at a third position, at which position the pick-up device 102 can pick up an electronic component 101 from the feeder 104. The camera 114 is configured to capture one or more images of the pick-up device 102 so that the coordinates of the third position can be determined. The coordinates of the pick-up position of the pick-up device 102 for the feeder 104 is obtained by adding the offset to the coordinates of the third position.

Only advantageous exemplary embodiments of the invention are described in the figures. It is clear to a person skilled in the art that the invention is not restricted only to the examples presented above, but the invention may vary within the limits of the claims presented hereafter. Some possible embodiments of the invention are described in the dependent claims, and they are not to be considered to restrict the scope of protection of the invention as such.

## Claims

1. An electronic component mounting device, comprising:
- a conveyor (110) for conveying a circuit board (103),
- feeders (104) for feeding electronic components (101),
- a pick-up device (102) for picking up electronic components (101) from the feeders (104) and mounting the electronic components (101) to the circuit board (103), and
- a movable frame (107) to which the feeders (104) are detachably attached, said movable frame (107) being movable between a first position at which the pick-up device (102) is intended to pick up electronic components (101) from the feeders (104) and a second position at which the feeders (104) are intended to be attached to and detached from the movable frame (107),
**characterised in that** the electronic component mounting device comprises a camera (114) for capturing one or more images of the movable frame (107) at the first position and the second position, and analysing means for analysing the one or more images using pattern recognition techniques to determine the coordinates of the first position and the second position and for calculating an offset between the first position and the second position based on the coordinates of the first and second positions, wherein the camera (114) is configured to capture one or more images of the pick-up device (102) at a third position, at which position the pick-up device (102) can pick up an electronic component (101) from a feeder (104) when the movable frame (107) is at the second position, and the analysing means is configured to analyse the one or more images using pattern recognition techniques to determine the coordinates of the third position and to calculate the coordinates of a pick-up position of the pick-up device (102) for picking up electronic components (101) from the feeder (104), when the movable frame (107) is at the first position, by adding the offset to the coordinates of the third position.

2. The electronic component mounting device according to claim 1, **characterised in that** the first position of the movable frame (107) is adjustable.

3. The electronic component mounting device according to claim 1 or 2, **characterised in that** the electronic component mounting device comprises locking means for locking the movable frame (107) at the first position and/or the second position.

4. The electronic component mounting device according to any of claims 1 to 3, **characterised in that** the electronic component mounting device comprises moving means (111, 112) for moving the pick-up device (102).

5. The electronic component mounting device according to any of claims 1 to 4, **characterised in that** the camera (114) is configured to capture one or more images of the circuit board (103), and the analysing means is configured to analyse the one or more images using pattern recognition techniques to determine the positions of calibration and electronic component mounting holes in the circuit board (103).

6. A method for setting up an electronic component mounting device that comprises a movable frame (107) to which feeders (104) are detachably attached and a pick-up device (102) for picking up electronic components (101) from the feeders (104) and mounting the electronic components (101) to a circuit board (103) that is conveyed with a conveyor (110), the method comprising:
- moving the movable frame (107) to a first position at which the pick-up device (102) is intended to pick up electronic components (101) from the feeders (104),
- determining the coordinates of the first position,
- moving the movable frame (107) to a second position at which the feeders (104) are intended to be attached to and detached from the movable frame (107),
- determining the coordinates of the second position,
- calculating an offset between the first position and the second position based on the coordinates of the first and second positions, and
- determining the coordinates of a pick-up position of the pick-up device (102) for each feeder (104) by
- moving the movable frame (107) to the second position,
- moving the pick-up device (102) to a third position at which the pick-up device (102) can pick up an electronic component (101) from a feeder (104), when the movable frame (107) is at the second position,
- determining the coordinates of the third position, and
- calculating the coordinates of the pick-up position of the pick-up device (102) for picking up electronic components (101) from the feeder (104), when the movable frame (107) is at the first position, by adding the offset to the coordinates of the third position.

7. The method according to claim 6, **characterised in that** the method comprises:
- changing the first position of the movable frame (107) by moving the movable frame (107) to a new first position and determining its coordinates, and
- repeating the steps of
- calculating an offset between the first position and the second position based on the coordinates of the first and second positions, and
- determining the coordinates of a pick-up position of the pick-up device (102) for each feeder (104).

8. The method according to claim 6 or 7, **characterised in that** the step of determining the coordinates of the first position and the step of determining the coordinates of the second position comprise:
- using a camera (114) to capture one or more images of the movable frame (107), and
- analysing the one or more images using pattern recognition techniques.

9. The method according to any of claims 6 to 8, **characterised in that** the step of determining the coordinates of the third position comprises:
- using a camera (114) to capture one or more images of the pick-up device (102), and
- analysing the one or more images using pattern recognition techniques.

10. The method according to any of claims 6 to 9, **characterised in that** the method comprises determining the positions of calibration and electronic component mounting holes in the circuit board (103).

11. The method according to claim 10, **characterised in that** the step of determining the positions of calibration and electronic component mounting holes in the circuit board (103) comprises:
- using a camera (114) to capture one or more images of the circuit board (103), and
- analysing the one or more images using pattern recognition techniques.

## Patentansprüche

1. Montagevorrichtung für elektronische Komponenten, umfassend:
- einen Förderer (110) zum Fördern einer Leiterplatte (103),
- Zuführungen (104) zum Zuführen elektronischer Komponenten (101),
- eine Aufnahmevorrichtung (102) zum Aufnehmen elektronischer Komponenten (101) von den Zuführungen (104) und zum Montieren der elektronischen Komponenten (101) auf der Leiterplatte (103) und
- einen beweglichen Rahmen (107), an dem die Zuführungen (104) abnehmbar angebracht sind,
wobei der bewegliche Rahmen (107) zwischen einer ersten Position, an der die Aufnahmevorrichtung (102) elektronische Komponenten (101) von den Zuführungen (104) aufnehmen soll, und einer zweiten Position, an der die Zuführungen (104) an dem beweglichen Rahmen (107) angebracht und von diesem gelöst werden sollen, beweglich ist,
**dadurch gekennzeichnet, dass** die Montagevorrichtung für elektronische Komponenten eine Kamera (114) zum Aufnehmen eines oder mehrerer Bilder des beweglichen Rahmens (107) an der ersten Position und der zweiten Position und Analysemittel zum Analysieren des einen oder der mehreren Bilder unter Verwendung von Mustererkennungstechniken, zum Bestimmen der Koordinaten der ersten Position und der zweiten Position und zum Berechnen eines Versatzes zwischen der ersten Position und der zweiten Position basierend auf den Koordinaten der ersten und zweiten Position umfasst, wobei die Kamera (114) konfiguriert ist, um ein oder mehrere Bilder der Aufnahmevorrichtung (102) an einer dritten Position aufzunehmen, an welcher Position die Aufnahmevorrichtung (102) eine elektronische Komponente (101) von einer Zuführung (104) aufnehmen kann, wenn sich der bewegliche Rahmen (107) in der zweiten Position befindet, und das Analysemittel konfiguriert ist, um das eine oder die mehreren Bilder unter Verwendung von Mustererkennungstechniken zu analysieren, um die Koordinaten der dritten Position zu bestimmen und die Koordinaten einer Aufnahmeposition der Aufnahmevorrichtung (102) zum Aufnehmen elektronischer Komponenten (101) von der Zuführung (104) zu berechnen, wenn sich der bewegliche Rahmen (107) an der ersten Position befindet, indem der Versatz zu den Koordinaten der dritten Position addiert wird.

2. Montagevorrichtung für elektronische Komponenten nach Anspruch 1, **dadurch gekennzeichnet, dass** die erste Position des beweglichen Rahmens (107) einstellbar ist.

3. Montagevorrichtung für elektronische Komponenten nach Anspruch 1 oder 2, **dadurch gekennzeichnet, dass** die Montagevorrichtung für elektronische Komponenten Verriegelungsmittel zum Verriegeln des beweglichen Rahmens (107) an der ersten Position und/oder der zweiten Position umfasst.

4. Montagevorrichtung für elektronische Komponenten nach einem der Ansprüche 1 bis 3, **dadurch gekennzeichnet, dass** die Montagevorrichtung für elektronische Komponenten Bewegungsmittel (111, 112) zum Bewegen der Aufnahmevorrichtung (102) umfasst.

5. Montagevorrichtung für elektronische Komponenten nach einem der Ansprüche 1 bis 4, **dadurch gekennzeichnet, dass** die Kamera (114) konfiguriert ist, um ein oder mehrere Bilder der Leiterplatte (103) aufzunehmen, und das Analysemittel konfiguriert ist, um das eine oder die mehreren Bilder unter Verwendung von Mustererkennungstechniken zu analysieren, um die Positionen von Kalibrierungs- und Montagelöchern für elektronische Komponenten in der Leiterplatte (103) zu bestimmen.

6. Verfahren zum Einrichten einer Montagevorrichtung für elektronische Komponenten, die einen beweglichen Rahmen (107) umfasst, an dem Zuführungen (104) abnehmbar angebracht sind, und eine Aufnahmevorrichtung (102) zum Aufnehmen elektronischer Komponenten (101) von den Zuführungen (104) und zum Montieren der elektronischen Komponenten (101) auf einer Leiterplatte (103), die mit einem Förderer (110) befördert wird, wobei das Verfahren Folgendes umfasst:
- Bewegen des beweglichen Rahmens (107) in eine erste Position, an der die Aufnahmevorrichtung (102) elektronische Komponenten (101) von den Zuführungen (104) aufnehmen soll,
- Bestimmen der Koordinaten der ersten Position,
- Bewegen des beweglichen Rahmens (107) in eine zweite Position, an der die Zuführungen (104) an dem beweglichen Rahmen (107) angebracht und von diesem gelöst werden sollen,
- Bestimmen der Koordinaten der zweiten Position,
- Berechnen eines Versatzes zwischen der ersten Position und der zweiten Position auf der Grundlage der Koordinaten der ersten und zweiten Position und
- Bestimmen der Koordinaten einer Aufnahmeposition der Aufnahmevorrichtung (102) für jede Zuführung (104) durch
- Bewegen des beweglichen Rahmens (107) in die zweite Position,
- Bewegen der Aufnahmevorrichtung (102) in eine dritte Position, an der die Aufnahmevorrichtung (102) eine elektronische Komponente (101) von einer Zuführung (104) aufnehmen kann, wenn sich der bewegliche Rahmen (107) an der zweite Position befindet,
- Bestimmen der Koordinaten der dritten Position und
- Berechnen der Koordinaten der Aufnahmeposition der Aufnahmevorrichtung (102) zum Aufnehmen elektronischer Komponenten (101) von der Zuführung (104), wenn sich der bewegliche Rahmen (107) an der ersten Position befindet, durch Addieren des Versatzes zu den Koordinaten der dritten Position.

7. Verfahren nach Anspruch 6, **dadurch gekennzeichnet, dass** das Verfahren Folgendes umfasst:
- Ändern der ersten Position des beweglichen Rahmens (107) durch Bewegen des beweglichen Rahmens (107) in eine neue erste Position und Bestimmen seiner Koordinaten und
- Wiederholen der folgenden Schritte
- Berechnen eines Versatzes zwischen der ersten Position und der zweiten Position basierend auf den Koordinaten der ersten und zweiten Position und
- Bestimmen der Koordinaten einer Aufnahmeposition der Aufnahmevorrichtung (102) für jede Zuführung (104).

8. Verfahren nach Anspruch 6 oder 7, **dadurch gekennzeichnet, dass** der Schritt des Bestimmens der Koordinaten der ersten Position und der Schritt des Bestimmens der Koordinaten der zweiten Position Folgendes umfassen:
- Verwenden einer Kamera (114) zum Aufnehmen eines oder mehrerer Bilder des beweglichen Rahmens (107) und
- Analysieren des einen oder der mehreren Bilder unter Verwendung von Mustererkennungstechniken.

9. Verfahren nach einem der Ansprüche 6 bis 8, **dadurch gekennzeichnet, dass** der Schritt des Bestimmens der Koordinaten der dritten Position Folgendes umfasst:
- Verwenden einer Kamera (114) zum Aufnehmen eines oder mehrerer Bilder der Aufnahmevorrichtung (102) und
- Analysieren des einen oder der mehreren Bilder unter Verwendung von Mustererkennungstechniken.

10. Verfahren nach einem der Ansprüche 6 bis 9, **dadurch gekennzeichnet, dass** das Verfahren das Bestimmen der Positionen von Kalibrierungs- und Montagelöchern für elektronische Komponenten in der Leiterplatte (103) umfasst.

11. Verfahren nach Anspruch 10, **dadurch gekennzeichnet, dass** der Schritt des Bestimmens der Positionen von Kalibrierungs- und Montagelöchern für elektronische Komponenten in der Leiterplatte (103) Folgendes umfasst:
- Verwenden einer Kamera (114) zum Aufnehmen eines oder mehrerer Bilder der Leiterplatte (103) und
- Analysieren des einen oder der mehreren Bilder unter Verwendung von Mustererkennungstechniken.

## Revendications

1. Dispositif de montage de composant électronique, comprenant :
- un convoyeur (110) pour transporter une carte de circuit imprimé (103),
- des lignes d'alimentation (104) pour alimenter des composants électroniques (101),
- un dispositif de prélèvement (102) pour prélever des composants électroniques (101) des lignes d'alimentation (104) et monter les composants électroniques (101) sur la carte de circuit imprimé (103), et
- un châssis mobile (107) auquel les lignes d'alimentation (104) sont fixées de manière amovible, ledit châssis mobile (107) pouvant se déplacer entre une première position dans laquelle le dispositif de prélèvement (102) est destiné à prélever des composants électroniques (101) des lignes d'alimentation (104) et une deuxième position dans laquelle les lignes d'alimentation (104) sont destinées à être fixées au châssis mobile (107) et détachées de celui-ci,
**caractérisé en ce que** le dispositif de montage de composant électronique comprend une caméra (114) pour capturer une ou plusieurs images du châssis mobile (107) dans la première position et la deuxième position, et un moyen d'analyse pour analyser les une ou plusieurs images à l'aide de techniques de reconnaissance de formes afin de déterminer les coordonnées de la première position et de la deuxième position et pour calculer un décalage entre la première position et la deuxième position sur la base des coordonnées des première et deuxième positions, dans lequel la caméra (114) est configurée pour capturer une ou plusieurs images du dispositif de prélèvement (102) dans une troisième position, position dans laquelle le dispositif de prélèvement (102) peut prélever un composant électronique (101) d'une ligne d'alimentation (104) lorsque le châssis mobile (107) se trouve dans la deuxième position, et le moyen d'analyse est configuré pour analyser les une ou plusieurs images à l'aide de techniques de reconnaissance de formes afin de déterminer les coordonnées de la troisième position et de calculer les coordonnées d'une position de prélèvement du dispositif de prélèvement (102) pour prélever des composants électroniques (101) de la ligne d'alimentation (104), lorsque le châssis mobile (107) se trouve dans la première position, en ajoutant le décalage aux coordonnées de la troisième position.

2. Dispositif de montage de composant électronique selon la revendication 1, **caractérisé en ce que** la première position du châssis mobile (107) est réglable.

3. Dispositif de montage de composant électronique selon la revendication 1 ou 2, **caractérisé en ce que** le dispositif de montage de composant électronique comprend un moyen de verrouillage pour verrouiller le châssis mobile (107) dans la première position et/ou la deuxième position.

4. Dispositif de montage de composant électronique selon l'une quelconque des revendications 1 à 3, **caractérisé en ce que** le dispositif de montage de composant électronique comprend un moyen de déplacement (111, 112) pour déplacer le dispositif de prélèvement (102) .

5. Dispositif de montage de composant électronique selon l'une quelconque des revendications 1 à 4, **caractérisé en ce que** la caméra (114) est configurée pour capturer une ou plusieurs images de la carte de circuit imprimé (103), et le moyen d'analyse est configuré pour analyser les une ou plusieurs images à l'aide de techniques de reconnaissance de formes afin de déterminer les positions de trous d'étalonnage et de montage de composant électronique dans la carte de circuit imprimé (103) .

6. Procédé d'assemblage d'un dispositif de montage de composant électronique qui comprend un châssis mobile (107) auquel des lignes d'alimentation (104) sont fixées de manière amovible et un dispositif de prélèvement (102) pour prélever des composants électroniques (101) des lignes d'alimentation (104) et monter les composants électroniques (101) sur une carte de circuit imprimé (103) qui est transportée avec un convoyeur (110), le procédé comprenant :
- le déplacement du châssis mobile (107) dans une première position dans laquelle le dispositif de prélèvement (102) est destiné à prélever des composants électroniques (101) des lignes d'alimentation (104),
- la détermination des coordonnées de la première position,
- le déplacement du châssis mobile (107) dans une deuxième position dans laquelle les lignes d'alimentation (104) sont destinées à être fixées au châssis mobile (107) et détachées de celui-ci,
- la détermination des coordonnées de la deuxième position,
- le calcul d'un décalage entre la première position et la deuxième position sur la base des coordonnées des première et deuxième positions, et
- la détermination des coordonnées d'une position de prélèvement du dispositif de prélèvement (102) pour chaque ligne d'alimentation (104)
- en déplaçant le châssis mobile (107) dans la deuxième position,
- en déplaçant le dispositif de prélèvement (102) dans une troisième position dans laquelle le dispositif de prélèvement (102) peut prélever un composant électronique (101) d'une ligne d'alimentation (104), lorsque le châssis mobile (107) se trouve dans la deuxième position,
- en déterminant les coordonnées de la troisième position, et
- en calculant les coordonnées de la position de prélèvement du dispositif de prélèvement (102) pour prélever des composants électroniques (101) de la ligne d'alimentation (104), lorsque le châssis mobile (107) se trouve dans la première position, en ajoutant le décalage aux coordonnées de la troisième position.

7. Procédé selon la revendication 6, **caractérisé en ce que** le procédé comprend en outre :
- la modification de la première position du châssis mobile (107) en déplaçant le châssis mobile (107) dans une nouvelle première position et en déterminant ses coordonnées, et
- la répétition des étapes de
- calcul d'un décalage entre la première position et la deuxième position sur la base des coordonnées des première et deuxième positions, et
- détermination des coordonnées d'une position de prélèvement du dispositif de prélèvement (102) pour chaque ligne d'alimentation (104) .

8. Procédé selon la revendication 6 ou 7, **caractérisé en ce que** l'étape de détermination des coordonnées de la première position et l'étape de détermination des coordonnées de la deuxième position comprend :
- l'utilisation d'une caméra (114) pour capturer une ou plusieurs images du châssis mobile (107), et
- l'analyse des une ou plusieurs images à l'aide de techniques de reconnaissance de formes.

9. Procédé selon l'une quelconque des revendications 6 à 8, **caractérisé en ce que** l'étape de détermination des coordonnées de la troisième position comprend :
- l'utilisation d'une caméra (114) pour capturer une ou plusieurs images du dispositif de prélèvement (102), et
- l'analyse des une ou plusieurs images à l'aide de techniques de reconnaissance de formes.

10. Procédé selon l'une quelconque des revendications 6 à 9, **caractérisé en ce que** le procédé comprend la détermination des positions de trous d'étalonnage et de montage de composant électronique dans la carte de circuit imprimé (103).

11. Procédé selon la revendication 10, **caractérisé en ce que** l'étape de détermination des positions de trous d'étalonnage et de montage de composant électronique dans la carte de circuit imprimé (103) comprend :
- l'utilisation d'une caméra (114) pour capturer une ou plusieurs images de la carte de circuit imprimé (103), et
- l'analyse des une ou plusieurs images à l'aide de techniques de reconnaissance de formes.
